# EUROPÄISCHE PATENTSCHRIFT

(11) **EP 1 603 237 B1**
(45) Veröffentlichungstag und Bekanntmachung des Hinweises auf die Patenterteilung: **30.11.2011**
(21) Anmeldenummer: 05017512.4
(22) Anmeldetag: 26.03.2004
(51) Int. Cl.: H03K 17/687, H03K 17/16

(54) **Elektronischer Schalter**
Electronic switch
Commutateur électronique

(30) Priorität: 30.06.2003 DE 10329394; 14.07.2003 DE 10331804
(43) Veröffentlichungstag der Anmeldung: 07.12.2005
(62) Teilanmeldung aus: 04007340.5
(73) Patentinhaber: Rohde & Schwarz GmbH & Co. KG, 81671 München (DE)
(72) Erfinder: Nöst, Peter, 81539 Mücnhen (DE)
(74) Vertreter: Körfer, Thomas

(56) Entgegenhaltungen:
- EP-A- 0 415 081
- FR-A- 2 612 022
- JP-A- 4 181 811
- US-A- 3 325 654
- US-A- 3 524 996
- US-A- 4 595 847
- US-A- 4 808 859
- US-A- 5 602 505
- US-B1- 6 201 455
- PATENT ABSTRACTS OF JAPAN Bd. 1998, Nr. 08, 30. Juni 1998 (1998-06-30) -& JP 10 084267 A (HITACHI LTD), 31. März 1998 (1998-03-31)
- YITZAK COHEN ET AL: "IMPROVED BIASING FOR A POWER MOSFET ACTING AS A SWITCH" MOTOROLA TECHNICAL DEVELOPMENTS, MOTOROLA INC. SCHAUMBURG, ILLINOIS, US, Bd. 14, 1. Dezember 1991 (1991-12-01), Seite 40, XP000276146 ISSN: 0887-5286

## Beschreibung

Die Erfindung betrifft einen elektronischen Schalter laut Oberbegriff des Anspruchs 1.

Elektronische Schalter werden in der Hochfrequenztechnik beispielsweise zum Schalten von Dämpfungsgliedern in Eichleitungen und dergleichen benutzt. Das zu schaltende Hochfrequenzsignal wird dabei im leitenden Zustand des Feldeffekt-Schaltransistors über den Source-Drain-Kanal dem Verbraucher zugeführt. Die Steuerung des Ein-Aus-Zustandes des Schalters erfolgt über ein dem Gate-Anschluß des Feldeffekt-Schalttransistors zugeführtes Steuersignal.

Im Frequenzbereich über etwa 100 MHz besitzen solche elektronischen Schalter ausgezeichnete Linearität, bei niedrigeren Frequenzen unter etwa 100 MHz wird die Linearität jedoch sehr schlecht und das zu schaltende Signal wird stark verzerrt. Dies ist darauf zurückzuführen, daß bei geschalteten Signalen mit niedrigen Frequenzen und Amplituden größer gleich der Abschnürspannung (Pinch-Off-Spannung) des Schalttransistors der Spannungsabfall zwischen Gate und Soruce bzw. Gate und Drain während der positiven Halbwelle des zu schaltenden Signals betragsmäßig die Pinch-Off-Spannung überschreitet. Der Schalttransistor wechselt so aufgrund des Signalverlaufes des zu schaltenden Signals in den AUS-Zustand.

Um dieses Niederfrequenz-Großsignal-Verhalten zu verbessern ist es aus der US 5,107,152 bekannt, einen relativ großen Gate-Vorwiderstand bzw. eine hochohmige Diode in Reihe dazu vorzusehen. Durch diese bekannten Maßnahmen werden jedoch die Umschaltzeiten des Schalters unnötig verlängert.

Aus der JP 10 084267 A ist ein elektronischer Schalter mit einem Feldeffekt-Schalttransistor bekannt der ein Hochfrequenzsignal mit einer großen Amplitude sicher ein-, bzw. ausschalten soll. Eine Koppelkapazität verbindet dabei den Drain-Anschluss über einen Widerstand mit dem Gate-Anschluss. Der nicht mit dem Drain-Anschluss verbundene Anschluss der Koppelkapazität ist weiterhin mit einer antiparallelen Diodenschaltung verbunden, wobei jeweils eine der beiden Dioden über ein Steuersignal zuschaltbar ist, sodass der Schalttransistor in den leitenden oder nicht-leitenden Zustand übergeht.

Aus der JP 4 181811 A ist ein Schalteinrichtung mit einem Feldeffekt-Schalttransistor bekannt, die die Aufgabe hat, ein Signal mit möglichst vielen Impulsen über den Feldeffekt-Schalttransistor zu übertragen. Hierzu wird der Gate-Anschluss des Feldeffekt-Schalttransistors mit einer antiparallelen Diodenschaltung verbunden, von der eine Diode mit der Bezugsmasse und die andere Diode mit der Versorgungsspannung verbunden ist, wobei die Diode, die mit ihrer Kathode mit der Bezugsmasse verbunden ist, über eine Schalteinheit zuschaltbar ist.

Es ist daher die Aufgabe der Erfindung, einen elektronischen Schalter dieser Art bezüglich seines

Niederfrequenz-Großsignal-Verhaltens zu verbessern, ohne dabei die sonstigen Eigenschaften des Schalters zu beeinträchtigen.

Diese Aufgabe wird ausgehend von einem elektronischen Schalter laut Oberbegriff des Anspruchs 1 durch die kennzeichnenden Merkmale des Anspruchs 1 gelöst. Vorteilhafte Weiterbildungen ergeben sich aus den Unteransprüchen.

Durch die erfindungsgemäßen Schaltungen wird gewährleistet, daß auch bei tiefen Frequenzen z. B. 10 kHz das Gate-Potential am Feldeffekt-Schalttransistor gleich groß oder durch den Gleichrichteffekt sogar größer als das Potential am Source- bzw. Drain-Anschluß ist und daher ein solcher elektronischer Schalter auch bei tiefen Frequenzen lineares Übertragungsverhalten besitzt und Signalverzerrungen vermieden werden.

Die Erfindung wird im Folgenden an Ausführungsbeispielen näher erläutert. In der Zeichnung zeigen:
- Fig. 1: ein erstes Ausführungsbeispiel eines nicht erfindungsgemäßen elektronischen Schalters;
- Fig. 2: ein zweites Ausführungsbeispiel des erfindungsgemäßen elektronischen Schalters;
- Fig. 3: die Signalspannungen V_{G}, V_{D}, V_{S} und V_{O} aus Fig. 1 als Funktion der Zeit t;
- Fig. 4: die Signalspannungen V_{G}, V_{D}, V_{S} und V_{O} aus Fig. 2 als Funktion der Zeit t und
- Fig. 5: die Signalspannungen V_{G}, V_{D}, V_{S} und V_{O} bei einem elektronischen Schalter ohne die erfindungsgemäßen Maßnahmen als Funktion der Zeit t.

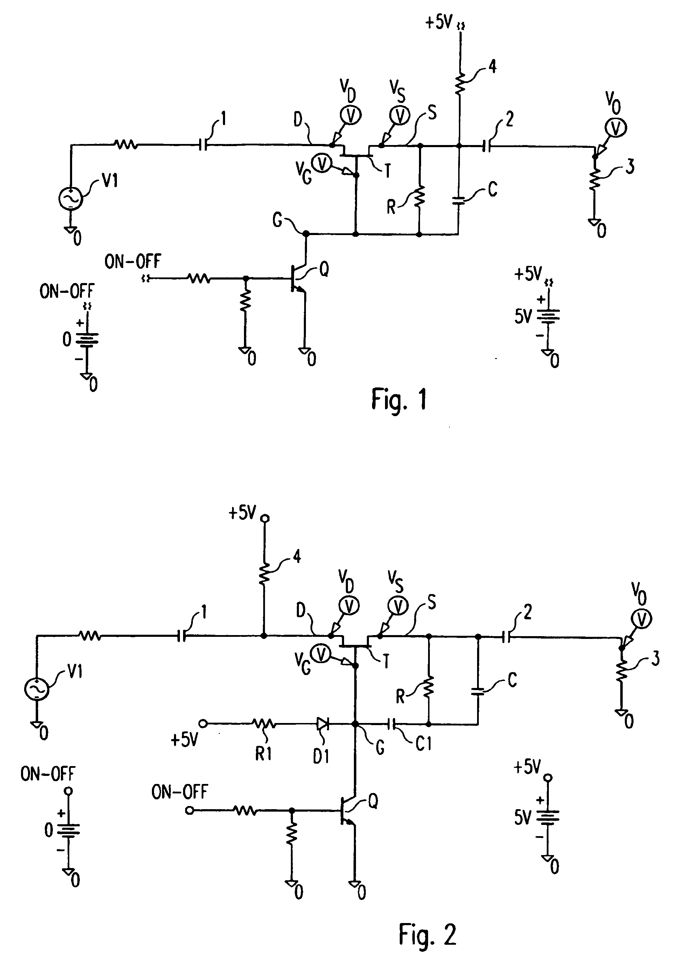

Fig. 1 zeigt ein nicht erfindungsgemäßes Beispiel. Das zu schaltende Hochfrequenzsignal V1 wird über einen Koppelkondensator 1 dem Drain-Anschluß D des Feldeffekt-Schalttransistors T zugeführt, beispielsweise einen Gallium-Arsenid-Halbleiter-Feldeffekttransistor (GaAsMESFET). Der Source-Anschluß S des Schalttransistors T ist über einen Koppelkondensator 2 mit dem Verbraucher 3 verbunden. Das Gleichspannungspotential für den Transistor T wird über einen Widerstand 4 zugeführt, im gezeigten Ausführungsbeispiel aus einer +5V-Quelle bei einem Bezugspotential der Schaltung von 0 V. Die Steuerung des Transistors T in den leitenden (ON) bzw. sperrenden (OFF) Zustand erfolgt über ein am Gate-Anschluß G zugeführtes Steuersignal. Dieses Steuersignal besteht im einfachsten Fall aus zwei verschiedenen Gleichspannungswerten, die wechselweise dem Gate-Anschluß G zugeführt werden. Im gezeigten Ausführungsbeispiel wird durch Anlegen einer Steuerspannung von 0 V der Transistor T durchgeschaltet (ON), bei Anlegen einer Spannung von +5 V dagegen abgeschaltet (gesperrt, OFF).

Im nicht erfindungsgemäßen Beispiel nach Fig. 1 zwischen Source-Anschluß S und Gate-Anschluß G die Parallelschaltung eines ohmschen Widerstandes R und eines Kondensators C angeordnet. Widerstand R und Kondensator C sind so dimensioniert, daß die Spannung am Gate-Anschluß G im durchgeschalteten Zustand amplitudengleich und phasengleich mit der Spannung am Source-Anschluß S ist. Die Dimensionierung hängt von der Art des verwendeten Feldeffekt-Schalttransistors sowie der Art der Zuleitungen zum Schalttransistor ab. Sie muß für den jeweiligen Transistortyp für niedrige Frequenzen jeweils so berechnet werden, daß die gewünschte Phasengleichheit an allen Anschlüssen des Transistors gewährleistet ist und damit auch bei tiefen Frequenzen die Spannung an den drei Anschlüssen des Schalttransistors jeweils gleich groß und in Phase ist, wie dies in Fig. 1 durch die Spannungsangaben V_{G} für die Gate-Spannung und V_{D} für die Drain-Spannung sowie V_{S} für die Source-Spannung angedeutet ist. V_{O} bezeichnet die Ausgangsspannung am Verbraucher 3.

Diese Mitführung des Gate-Potentials mit dem Signal-Potential kann auch vom Drain-Potential des Schalttransistors T abgeleitet werden, indem der Widerstand R mit parallel geschaltetem Kondensator C zwischen Drain-Anschluß D und Gate-Anschluß G angeordnet wird.

Fig. 2 zeigt ein Ausführungsbeispiel für die erfindungsgemäße Lösungsmöglichkeit. Am Gate-Anschluß G ist mit ihrer Kathode eine Diode D1 angeschlossen, deren Anode über einen Widerstand R1 mit dem Gleichspannungspotential des Schalttransistors T, im Beispiel +5 V, vorgespannt ist. Durch diese Diode D1 werden im ON-Zustand die über die Source-Gate-Streukapazität bzw. die Drain-Gate-Streukapazität des Schalttransistors T oder durch eine zusätzliche Kapazität (siehe C1 Fig. 2) zum Gate gekoppelten Wechselspannungs-Signalanteile gleichgerichtet und hierdurch die Gate-Spannung geringfügig höher als die Source- bzw. Drain-Spannung. Dadurch wird das eingangs geschilderte Niederfrequenz-Großsignal-Verhalten verbessert.

Dieser Effekt wird dadurch verbessert, daß zusätzlich zur Diode D1 zwischen Source S oder Drain D und Gate G eine Reihenschaltung eines Widerstandes R und eines Trennkondensators C1 angeordnet wird.

Zur Verringerung einer etwaigen Phasenverschiebung zwischen Source- und Gatespannung kann zusätzlich zur Reihenschaltung R-C1 eine Kapazität C parallel zu R angebracht werden. Im Ausführungsbeispiel ist das Gleichspannungs-Potential des Schalttransistors T +5 V. In Anwendungsfällen, in denen das Gleichspannungspotential 0 V ist, wird die Diode D1 natürlich entsprechend mit 0 V vorgespannt. Selbstverständlich ist diese Art der Gate-Spannungserhöhung mittels einer zusätzlichen Diode auch in den Fällen anwendbar, in denen die Hochfrequenz-Signalzufuhr über die Parallelschaltung des Widerstandes mit dem Kondensator nicht vom Source-Anschluß sondern vom Drain-Anschluß erfolgt.

In den Ausführungsbeispielen nach Fig. 1 und 2 erfolgt die Zuführung des Steuersignals zum Gate-Anschluß G über einen in Reihe zwischen Gate-Anschluß G und Bezugspotential geschalteten Transistor Q, der als bipolarer Transistor oder Feldeffekt-Transistor ausgebildet ist und eine verglichen mit den parasitären Kapazitäten zwischen Drain-Gate bzw. Source-Gate des Schalttransistors T geringe Kollektor-Emitter-Kapazität bzw. beim Feldeffekt-Transistor geringe Source-Drain-Kapazität besitzt.

Im ON-Zustand des Schalttransistors T (ON-Steuerspannung = 0 V) ist der Transistor Q hochohmig und die über den Widerstand R und den Kondensator C zum Gate-Anschluß geführte Mitführspannung kann am Gate voll wirksam werden. Im gesperrten Zustand (OFF-Steuerspannung = 5 V) ist der Transistor Q sehr niederohmig und das Gate-Potential des Schalttransistors T wird annähernd 0 V. Das durch den Spannungsteiler 4/R bestimmte Drain-Potential des Schalttransistors wird in etwa 5 V. Somit sperrt der Schalttransistor und es kann kein Hochfrequenzsignal V1 zum Verbraucher 3 gelangen.

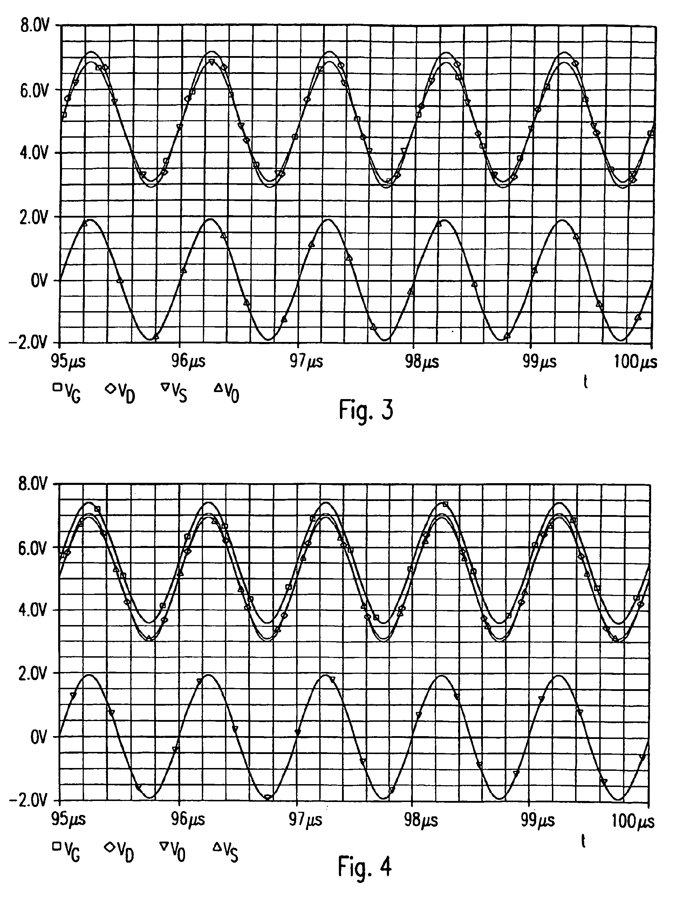

Fig. 3 zeigt zum besseren Verständnis die Gate-Spannung V_{G}, die Drain-Spannung V_{D}, die Source-Spannung V_{S} und die Ausgangsspannung V_{O} des in Fig. 1 dargestellten Ausführungsbeispiels als Funktion der Zeit t.

Weiterhin zeigt Fig. 4 die Gate-Spannung V_{G}, die Drain-Spannung V_{D}, die Source-Spannung V_{S} und die Ausgangsspannung V_{O} für das Ausführungsbeispiel der Fig. 2 als Funktion der Zeit t.

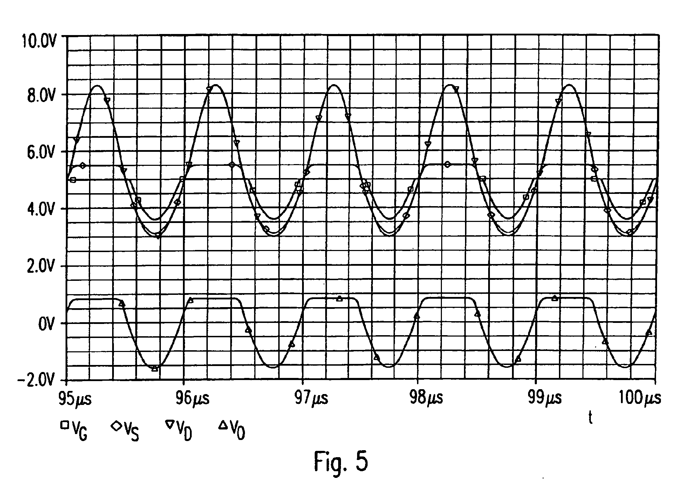

Zum Vergleich zeigt die Fig. 5 die Gate-Spannung V_{G}, die Drain-Spannung V_{D}, die Source-Spannung V_{S} und die Ausgangsspannung V_{O} für eine Ausführung ohne die erfindungsgemäßen Maßnahmen als Funktion der Zeit t.

Deutlich erkennbar ist, daß durch die erfindungsgemäßen Maßnahmen für tiefere Frequenzen eine erhebliche Linearisierung geschaffen wird.

## Patentansprüche

1. Elektronischer Schalter mit einem Feldeffekt-Schalttransistor (T), an dessen Drain-Anschluß (D) ein zu schaltendes Signal (V1), an dessen Source-Anschluß (S) das geschaltete Signal und an dessen Gate-Anschluss (G) ein den Schalttransistor (T) zwischen leitendem und nichtleitendem Zustand steuerndes Steuersignal anliegt,
**dadurch gekennzeichnet,**
**dass** zwischen Source-Anschluss (S) oder Drain-Anschluss (D) und dem Gate-Anschluss (G) eine Serienschaltung eines Kondensators (C1) mit einem ersten Widerstand (R) geschaltet ist,
**dass** am Gate-Anschluss (G) eine vorgespannte Diode (D1) angeschlossen ist und zwar mit ihrem ersten Pol am Gate-Anschluss (G) und mit ihrem anderen Pol über einen zweiten Widerstand (R1) an einem Gleichspannungspotential (z.B. +5V), das auch dem Schalttransistor (T) über einen dritten Widerstand (4) zugeführt ist,
und **dass** das Steuersignal über einen Bipolar- oder Feldeffekt-Transistor (Q) dem Gate-Anschluss (G) zugeführt ist, der eine verglichen mit den parasitären Kapazitäten des Schalttransistors (T) kleine Kollektor-Emitter- bzw. Source-Drain-Kapazität aufweist.

## Claims

1. Electronic switch with a field-effect switching transistor (T), to the drain terminal (D) of which a signal (V1) to be switched is connected, to the source terminal (S) of which the switched signal is connected, and to the gate terminal (G) of which a control signal controlling the switching transistor (T) between a conductive and non-conductive condition is connected,
**characterised in that**,
between the source terminal (S) or the drain terminal (D) and the gate terminal (G), a series circuit of a capacitor (C1) is switched to a first resistor (R),
that, at the gate terminal (G), a biased diode (D1) is connected and, in fact, with its first pole to the gate terminal (G) and with its other pole, via a second resistor (R1), to a direct voltage potential (for example, +5V), which is also supplied to the switching transistor (T) via a third resistor (4), and that
the control signal is supplied via a bipolar or field-effect transistor (Q) to the gate terminal (G), which provides a small collector-emitter capacitance or respectively source-drain capacitance by comparison with the parasitic capacitances of the switching transistor (T).

## Revendications

1. Commutateur électronique comportant un transistor de commutation à effet de champ (T), à la borne de drain (D) duquel est délivré un signal à commuter (V1), à la borne de source (S) duquel est délivré le signal commuté et à la borne de grille (G) duquel est délivré un signal de commande commandant le transistor de commutation (T) entre un état conducteur et un état non conducteur,
**caractérisé en ce que**
entre la borne de source (S) ou la borne de drain (D) et la borne de grille (G) est monté un circuit série d'un condensateur (C1) avec une première résistance (R),
**en ce qu'**à la borne de grille (G) est reliée une diode polarisée (D1) avec son premier pôle relié à la borne de grille (G) et son autre pôle par l'intermédiaire d'une seconde résistance (R1) relié à un potentiel électrique continu (par exemple +5V), qui est délivré par l'intermédiaire d'une troisième résistance (4) également au transistor de commutation (T), et
**en ce que** le signal de commande est délivré par l'intermédiaire d'un transistor bipolaire ou à effet de champ (Q) à la borne de grille (G), qui présente une faible capacité collecteur-émetteur ou source-drain par rapport aux capacités parasites du transistor de commutation (T).
